# EUROPEAN PATENT SPECIFICATION

(11) **EP 1 193 327 B1**
(45) Date of publication and mention of the grant of the patent: **10.11.2004**
(21) Application number: 01122851.7
(22) Date of filing: 24.09.2001
(51) Int. Cl.: C23C 16/44, C03C 15/00, C03C 19/00, C23C 16/458

(54) **Silica glass apparatus for semiconductor industry and method for producing the same**
Quarzglas Vorrichtungen für die Halbleiter Industrie und Verfahren zur deren Herstellung
Dispositif pour la fabrication des sémiconducteurs en verre de silice et procédé de fabrication du dispositif

(30) Priority: 28.09.2000 JP 2000296733; 28.09.2000 JP 2000296756
(43) Date of publication of application: 03.04.2002
(73) Proprietor: Heraeus Quarzglas GmbH & Co. KG, 63450 Hanau (DE); Shin-Etsu Quartz Products Co., Ltd., Shinjuku-ku, Tokyo 160-0023 (JP)
(72) Inventor: Segawa, Tohru, Koriyama-shi, Fukushima 963-0101 (JP); Sato, Tatsuhiro, Vancouver WA 98684 (US); Maruko, Yoichiro, Sasebo-shi, Nagasaki 859-3241 (JP); Inaki, Kyoichi, Tokorozawa-shi, Saitama 359-1102 (JP)
(74) Representative: Kühn, Hans-Christian

(56) References cited:
- WO-A-98/44538
- PATENT ABSTRACTS OF JAPAN vol. 1999, no. 10, 31 August 1999 (1999-08-31) -& JP 11 130451 A (SHINETSU QUARTZ PROD CO LTD), 18 May 1999 (1999-05-18)
- PATENT ABSTRACTS OF JAPAN vol. 1998, no. 08, 30 June 1998 (1998-06-30) & JP 10 059744 A (SHINETSU QUARTZ PROD CO LTD), 3 March 1998 (1998-03-03)
- PATENT ABSTRACTS OF JAPAN vol. 1996, no. 04, 30 April 1996 (1996-04-30) & JP 07 315872 A (SHINETSU QUARTZ PROD CO LTD), 5 December 1995 (1995-12-05)
- O'HANLON J F: "ADVANCES IN VACUUM CONTAMINATION CONTROL FOR ELECTRONIC MATERIALS PROCESSING" JOURNAL OF VACUUM SCIENCE AND TECHNOLOGY: PART A, AMERICAN INSTITUTE OF PHYSICS. NEW YORK, US, vol. 5, no. 4, PART 3, 1 July 1987 (1987-07-01), pages 2067-2072, XP000036372 ISSN: 0734-2101

## Description

### Industrial Field of Application

The present invention relates to a silica glass jig for semiconductor industry, particularly to a silica glass jig for semiconductor industry, wherein small projections are uniformly distributed on the surface thereof, and also to a production method thereof.

### Prior Art

Hitherto, in the production of semiconductor elements, it has been carried out to form a coat made of coating material such as silicon oxide, silicon nitride or polysilicon, etc., on a substrate and in this case, the coating material deposits not only on the substrate but also on the surfaces of the inside of a reaction chamber for carrying out coating and on the surface of members disposed in the reaction chamber (hereinafter, the reaction chamber and the members are referred to as simply jigs). When the jig is made of a silica glass and when the thickness of the coated material becomes thicker than a definite thickness, by the difference in the thermal expansion coefficients between the jig and the coated material, a stress is generated to cause peeling off or form particles, which cause to contaminate the semiconductor elements. Particularly, in the case of forming the coat by a CVD process of a high temperature, the tendency of causing peeling off is more increased. Accordingly, it is general to wash the jig after using for a definite time, but washing takes a long time as well as increases a step number, which results in increasing the production cost. In the case of growing a polysilicon film on a semiconductor element by an LPCVD (Low Pressure Chemical Vapor Deposition) method, it is effective that the quartz glass jig has formed on the surface many irregularities. By the irregularities, the generation of stress by the difference in the thermal expansion coefficients between a polysilicon film deposited on the surface of the quartz glass jig and the quartz glass jig is reduced and the occurrence of releasing of the film and the formation of cracks can be prevented. For the formation of the above-described irregularities, machining is used, but by the machining, a layer having microcracks is formed under the irregularity-formed surface formed in the jig and the depth of the cracks sometimes reaches 100 µm. When such deep cracks occur, substances of contaminating a semiconductor element enter the cracks, and at the heat treatment of the semiconductor element, it sometimes happens that the substances are volatized to contaminate the semiconductor element. Accordingly, in the initial stage of the treatment of semiconductor element, after operating the process for a while without using semiconductor element, the treatment is carried out. Also, the above-described cracks become cracks of initiating the destruction of the jig to lower the strength of the jig and shorten the usable life of the jig as well as there are the faults that at washing or cleaning the jig, the irregularities of the jig are changed, the surface state of the jig is changed, and a homogeneous vapor-phase reaction cannot be carried out. For solving the faults, for example, Japanese Patent Laid-Open No. 59744/1998 proposed that a machined jig is subjected to an etching treatment with hydrofluoric acid containing from 3 to 20% by mass of hydrogen fluoride to release the microcracks, whereby the microcrack-free surface is formed. However, in the jig treated by the method, the irregularities become too large to form cone-shaped concave portions, the fine irregularities are reduced, and thus the jig is unsatisfactory as a jig for treating semiconductor elements.

Also, a method of forming the irregularities on the surface of a silica glass jig by a chemical treatment without using machining is proposed, for example, in Japanese Patent Laid-Open No. 106225/1999. In the chemical treatment, microcracks are not formed in a jig, the contamination of semiconductor elements by contaminants from the insides of cracks does not occur, also, at washing of the jig, the irregularities on the surface of the jig are scarcely changed, and a homogeneous chemical reaction can be carried out. However, in the method, there are problems that when large irregularities, such as, for example, the roughness Ra of at least 3 are formed, smooth portions exist at the slanting surfaces of the convex portions and the bottom portions of the concaves, polysilicon attaches to the smooth portions, by the difference in the thermal expansion coefficients between the attached polysilicon film and the jig, cracks occur in the jig to for particles, which give bad influences on semiconductor elements and lower the yield thereof.

A further method of forming irregularities on the surface of a silica jig is known from WO-A-98/44538. A quartz glass component for use in the manufacture of semiconductors is exposed to an etching solution that cuts repeated steps in irregular elevated structural elements which extend between a first, higher plane and a second, lower plane. The structural elements have a substantially even covering surface, and the steps are etched only in the sides of the elevated structural portions. With the surface structure of the known quartz glass article satisfying adhesion of CVD coats can be achieved as long as the average size of the substantially flat structural elements does not exceed 180µm.

### Problems that the Invention is to Solve

In view of these circumstances, as the results of making various investigations, the present inventors have found that by treating a mechanically roughened silica glass jig with a specific aqueous solution a silica glass jig, wherein microcracks are released and there is no entering of decontaminates, is obtained and by uniformly distributing many small projections on the surface of the jig, a silica glass jig having no occurrence of cracks by the difference in the thermal expansion coefficients between the jig and an attached film such as a polysilicon film, etc., is obtained, and have accomplished the present invention.

The present inventors further made the investigations based on the consideration that an excellent quartz glass jig was obtained by improving the chemical processing method it was found that by first forming relatively large pyramidal projections with their cut-off apices by the chemical processing method and further forming small projections on the above-described projections, a quartz glass jig, which more reduces the occurrence of peeling off of film, causes very less formation of cracks by the difference in the thermal expansion coefficients between the jig and the coated material, and can reduce the washing times of the jig, is obtained and have accomplished the present invention. An object of the invention is to provide a silica glass jig for semiconductor industry, which causes less peeling off of coated film, does not generate impurities contaminating semiconductor elements at the use thereof, and can reduce the washing times of jig, as well as causes less formation of cracks and shows a prolonged usable life.and does not cause cracks.

Also, another object of the invention is to provide a method of producing the above-described silica glass jig for semiconductor industry.

### Means for Solving the Problems

The present invention has been made for attaining the above-described objects, and the invention is a silica glass jig for semiconductor industry, characterized by having on the surface of the above-described jig, pyramidal projected structures with their cut-off apices and concave portions provided therebetween, and having small projections which are uniformly distributed thereon and a production method thereof.

The silica glass jig for semiconductor industry of the invention is a jig, which is used in a semiconductor industry such as, for example, a furnace core tube, a boat for placing a wafer, etc., and on the surface of the jig, there are pyramidal projected structures with their cut-off apices and also small projections are further uniformly distributed on the smooth portions between them.

For the silica glass jig of the invention a surface with many small dimpled concave portions each having a width of from 20 to 300 µm is preferred, on which there are grooves each having a width of from 0.5 to 50 µm at an interval of from 20 to 300 µm, and between the grooves and in the grooves, small projections each having a width of from 1 to 50 µm and a height of from 0.1 to 10 µm are uniformly distributed.

The silica glass jig for semiconductor industry of the invention is a jig, such as, for example, a furnace core tube, a boat for placing a wafer, etc., wherein on the surface of the silica glass jig, many small dimpled concave portions each having a width of from 20 to 300 µm exist at a part or the whole portions thereof, there are grooves having a width of from 0.5 to 50 µm at an interval of from 20 to 300 µm, and small projections having a width of from 1 to 50 µm and a height of from 0.1 to 10 µm are uniformly distributed between the grooves and in the grooves. By having the above-described structure, the silica glass jig for semiconductor industry of the invention forms less particles and impurities, can keep the high cleanness of the surface, and can sufficiently shows the high-pure performance as the bulk of the silica glass. In the silica glass jig of the invention, even when, for example, a polysilicon film is deposited on the surface thereof, the stress based on the different in the thermal expansion coefficients is moderated by the above-described small projections, cracks are hard to occur in the jig, and the life of the jig is prolonged. The above-described grooves are the portions formed by releasing deep microcracks occurred in the case of machining, the width thereof is preferably in the range of from 0.5 to 50 µm. When the width of the grooves is shorter than 0.5 µm, the extension of the microcracks is insufficient and the residue of impurities remains, while when the width of the grooves exceeds 50 µm, the etching off amount of the surface is large, whereby the dimensional precision is out of order. Also, the interval of the grooves changes according to the machining means but is preferably in the range of from 20 to 300 µm. Furthermore, between the grooves, there are small dimpled concave portions and the width thereof is in the range of from 20 to 300 µm. Also, between these groups and in the grooves, small projections are uniformly distributed. The sizes of the small protections differ according to the kind of the treating solution used but it is better that the width is in the range of from 1 to 50 µm and the height is in the range of 0.1 to 10 µm. When the sizes of the small projections are less than the above-described ranges, the moderation of the heat stress of the accumulated film is insufficient and cracks sometimes occur, while when the sizes exceed the above-described range, smooth portions remain.

It is preferred that in the above-described projected structures, the maximum width of the bottom portions thereof is from 70 to 1000 µm, and the height from the bottom portions to the top portions is in the range of from 10 to 100 µm. When the maximum width of the bottom portions of the projected structures is shorter than 70 µm, the surface roughness is small and thus the effect at the formation of a thick-coated film is insufficient, while the formation of the structures, in which the maximum width of the bottom portions exceeds 1000 µm, is technically difficult. Also, the height of the projected structures is lower than 10 µm, the irregularities are shallow and thus the peeling off preventing effect is insufficient, while the formation of the protected structures, in which the height exceeds 100 µm, is difficult.
It is better that in the small projections formed on the projected structures and the sides thereof, and on the flat portions of the concave portions between the projected structures, the maximum width of the bottom portions thereof is 50 µm or shorter and the height from the bottom portions to the top portions is lower than 10 µm. When the maximum width of the small projections exceeds 50 µm, flat portions remain and cracks and particles are liable to form. Because the silica glass jig for semiconductor industry of the invention has the above-described surface structure, the formation of cracks by the difference in the thermal expansion coefficients between the jig and the deposited film can be reduced, the occurrence of peeling off of the film deposited on the jig is less, and the washing times of the jig having attached thereto a thick film can be reduced.

It is another object of the invention to provide a method for producing a silica glass jig for semiconductor industry by machining the surface of the silica glass jig to form irregularities, and then treating the resulting surface with a treating solution containing hydrogen fluoride and ammonium fluoride. Particularly, a treating solution containing from 10 to 30% by mass of hydrogen fluoride, from 5 to 30% by mass of ammonium fluoride, and resin being water is preferred and further, the treating solution may further preferably contain an organic carboxylic acid in the range of from 45 to 70% by mass. By containing the organic carboxylic acid, the small projections having the sizes of the above-described range can be uniformly and easily formed. As the organic carboxylic acid, there are water-soluble organic carboxylic acids such as formic acid, acetic acid, propionic acid, etc. In these organic carboxylic acids, acetic acid is particularly preferred because of the high solubility in water and a low cost.

In the production method of the invention, first, the surface of a silica glass jig is roughened by machining as described above, and as the machining method, there are a sand blast method of blowing silicon dioxide fine particles, carbon fine particles, or ceramic fine particles, a grinding method using diamond grindstone particles, and a wet blast method using a slurry-form free grindstone particles. In these methods, the sand blast method is preferred. By the sand blast method, a glass powder is easily released from the surface of the jig and also there occurs no penetration of a coolant liquid into microcracks. Then, after machining, particles attached are removed by washing, the jig is repeatedly immersed in a treating solution containing from 10 to 30% by mass of hydrogen fluoride and from 5 to 30% by mass of ammonium fluoride, and rest being water, and preferably further containing an organic carboxylic acid in the range of from 45 to 70% by mass, whereby the microcracks are released to form many grooves having a width of from 0.5 to 50 µm and to form small dimpled concave portions each having a width of from 20 to 300 µm between the grooves, and further to make small projections having a width of from 1 to 50 µm and a height of from 0.1 to 10 µm uniformly distribute between the grooves and in the grooves. When the amount of the organic carboxylic acid contained in the treating solution is less than 45% by mass, the small projections become large and the uniform distribution thereof becomes difficult, while when the amount of the organic carboxylic acid exceeds 70% by mass, the small projections become too small, whereby the effect thereof is not obtained. Also, when the content of ammonium fluoride in the processing solution is less than 5% by mass, etching by hydrogen fluoride only occurs, while when the content of ammonium fluoride exceeds 30% by mass, only the irregularities by about 30% by mass of ammonium fluoride are formed, the cost is increased, and thus the use of the excessive amount of ammonium fluoride is not suitable for practical use.

Alternatively, the present invention provides a method for production of the silica glass jig for semiconductor industry, in which first, a silica glass jig is immersed in a first treating solution containing hydrogen fluoride, ammonium fluoride, and an organic acid, and then the jig is immersed at least once in a second treating solution having a larger content of the organic acid than that of the above-described treating solution, whereby pyramidal projected structures with their cut-off apices and concave portions provided therebetween are formed on the surface of the jig and also small projections are uniformly distributed on them. It is better that the content of hydrogen fluoride in the first treating solution used is from 15 to 50% by mass, the content of ammonium fluoride is from 6 to 30% by mass, and the content of the organic acid is in the range of from 30 to 50% by mass. Also, it is better that the content of hydrogen fluoride in the second treating solution is from 5 to 20% by mass, the content of ammonium fluoride is from 6 to 30% by mass, and the content of the organic acid is in the range of from 40 to 70% by mass, the range of the organic acid is selected such that the range is more than the range thereof in the first treating solution.

When the content of ammonium fluoride in the above-described first treating solution is less than 6% by mass, etching by hydrogen fluoride only occurs and irregularities are not formed, and when the content of ammonium fluoride exceeds 30% by mass, the effect of forming irregularities is same, and the cost is increased, and thus the excessive use of ammonium fluoride is not suitable for practical use. Also, when the content of the organic acid is less than 20% by mass, the effect of containing the organic acid is less, and when the content of the organic acid exceeds 50% by mass, the projected structures become too small and the effect at the formation of thick film is insufficient. Furthermore, when the content of ammonium fluoride in the second treating solution is less than 6% by mass, etching by hydrogen fluoride only occurs and irregularities are not formed, and also when the content of the organic acid is less than 40% by mass, projections become too large, and the preparation of the treating solution, in which the content of the organic acid exceeds 70% by mass, is difficult.

As the organic acid, a water-soluble organic carboxylic acid is particularly preferred, practically, there are formic acid, acetic acid, propionic acid, etc., and in these acids, acetic acid, which has a high solubility in water and is inexpensive, is suitable.

### Mode for Carrying Out the Invention

Then, the example of the invention is described but the invention is not limited to the example.

### Examples

### Example 1:

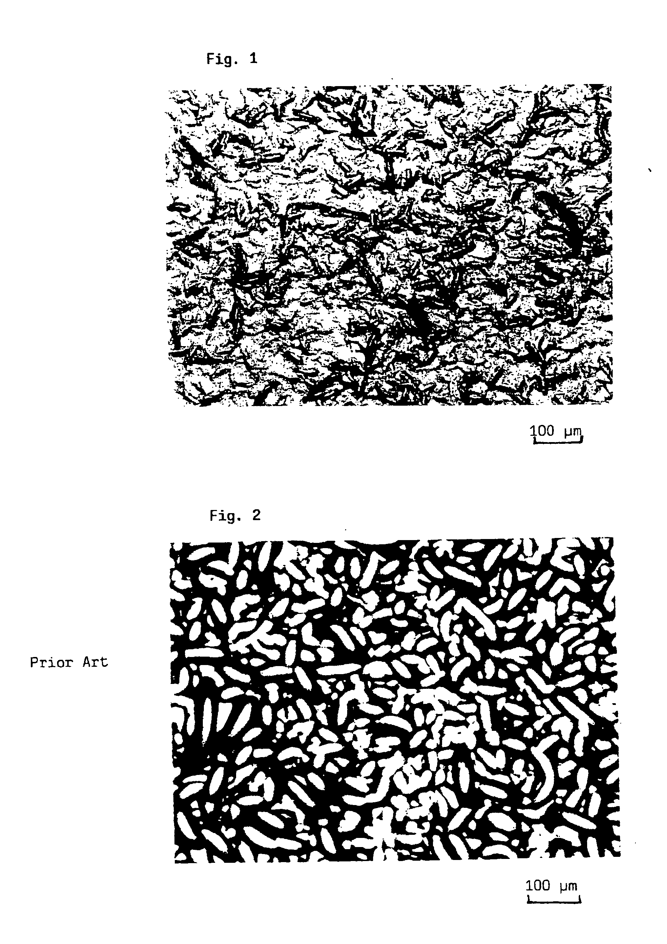

Using silicon carbide abrasives (#320), the inside surface of a furnace core tube for LPCVD was subjected to a sand blast work by blowing the abrasives using compressed air. The surface roughness Ra was 3 µm. When the furnace core tube was immersed in a treating solution bath of 15% by mass of hydrogen fluoride, 15% by mass of ammonium fluoride and 50% by mass of acetic acid for one hour and the furnace core tube after the treatment was observed by a scanning electron microscope, many small projections were observed as shown in Fig. 1. Also, microcracks were opened and many grooves having a width of about 1 µm were observed. Using the furnace core tube, a CVD process of forming a polysilicon film on a silicon wafer was carried out. The furnace core tube was used until the polysilicon film of 30 µm thick was attached but the generation of particles was less and the yield for the silicon wafer was high. Also, in the polysilicon film-attached furnace core tube after use, cracks were not generated and the film was not peeled off.

### Example 2:

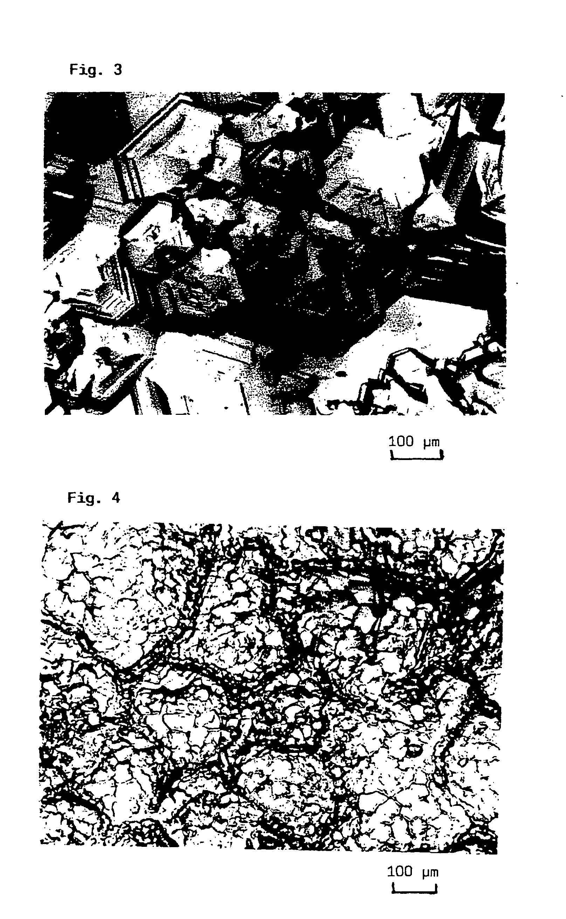

Alternativly a treating bath can be used containing 30% by mass of hydrogen fluoride, 10% by mass of ammonium fluoride, and 35% by mass of acetic acid for one hour to obtain the furnace core tube having pyramidal projected structures with their cut-off apices having the maximum width of the bottom portions of 300 µm and a height from the bottom portions to the top portions of 30 µm, and concave portions provided therebetween. As to the dimensions of the projected structures, the scanning electron microphotograph of the furnace core tube treated as described above was taken as shown in Fig. 3, the maximum width of the bottom portion of each of the projected structures, and the height from the bottom portion to the top portion of each projected structure were determined and the dimensions were shown as the mean value. When the treated furnace core tube was measured by a roughness meter, the average roughness Ra was 3 µm. The furnace core tube was further immersed in a treating solution of 15% by mass of hydrofluoric acid, 15% by mass of ammonium fluoride, and 50% by mass of acetic acid. When the surface of the furnace core tube obtained was observed by a scanning electron microscope, small projections having the maximum width of the bottom portions of 15 µm and the height from the bottom portion to the top portion of 2 µm were uniformly distributed as shown in Fig. 4. The average roughness Ra of the furnace core tube was 3.5 µm and the whole body was opaque. Using the furnace core tube, the formation of a polysilicon film on a silicon wafer was carried out by CVD process. The furnace core tube was used until the polysilicon film of 30 µm thick was attached to the furnace core tube, particles were not generated and the silicon wafer was treated with a high yield. Also, in the polysilicon film-attached furnace core tube after use, cracks were not generated and the film was not peeled off.

### Comparative Example 1:

Using a furnace core tube subjected to the sand blast work as in Example 1, the CVD process of forming a polysilicon film on a silicon wafer was carried out as in Example 1. After the initiation of the CVD treatment, many particles were generated, whereby the treatment of the wafer could not carried out for a while. Thereafter, the furnace core tube was used until the polysilicon film of 30 µm thick was attached, some cracks generated but the film was not peeled off:

### Comparative Example 2:

The furnace core tube subjected to the sand blast work in Example 1 was subjected to an etching treatment with 20% by mass of hydrogen fluoride for one hour. The surface roughness Ra of the jig obtained was 7 µm. When the surface thereof was observed by a scanning electron microscope, many smooth dimple-form (mortar-form) concave portions were observed as shown in Fig. 2. Using the furnace core tube, the CVD treatment as in Example 1 was carried out. After attaching a polysilicon film of 15 µm thick to the jig, the generating amount of particles was increased and the treatment became difficult. Also, in the jig after use, many cracks were observed and a part of the polysilicon film was peeled off.

### Advantage of the invention

In the silica glass jig for semiconductor industry of the present invention, many dimple-form concave portions having a width of from 20 to 300 µm exist on the surface thereof, there are grooves having a width of from 0.5 to 50 µm at an interval of from 20 to 300 µm on the surface, and small projections having a width of from 1 to 50 µm and a height of from 0.1 to 10 µm are uniformly distributed between the grooves and in the grooves, whereby the generation of particles of, for example, a polysilicon film, etc., during the use thereof is reduced, the formation of cracks is less, and the jig can be used with a prolonged life. The above-described silica glass jig can be produced by a simple method of roughening by machining, which has hitherto been used, and, in succession, treating with a treating solution containing hydrogen fluoride and ammonium fluoride of specific concentrations, and the industrial value thereof is high.

### Brief Description of the Drawings

- Fig. 1: is a photograph of 100 magnifications of the surface of a silica glass jig of the present invention by a scanning electron microscope.
- Fig. 2: is a photograph of 100 magnifications of the surface of a silica glass jig of prior art, which is obtained by sandblasting and by an etching treatment using hydrogen fluoride, by a scanning electron microscope.
- Fig. 3: is a photograph of 100 magnifications of the surface of a silica glass jig treated with the first processing solution, by a scanning electron microscope.
- Fig. 4: is a photograph of 100 magnifications of the surface of a silica glass jig treated with the first and second processing solutions, by a scanning electron microscope.

## Claims

1. A silica glass jig for semiconductor industry, **characterized by** having on the surface of the above-described jig, pyramidal projected structures with their cut-off apices and concave portions therebetween, and small projections are uniformly distributed thereon.

2. A silica glass jig for semiconductor industry described in Claim 1, **characterized in that**, on the surface thereof, the concave portions are dimpled and each having a width of from 20 to 300 µm, and there are grooves each having a width of from 0.5 to 50 µm at an interval of from 20 to 300 µm, and between the grooves and in the grooves, small projections each having a width of from 1 to 50 µm and a height of from 0.1 to 10 µm are uniformly distributed.

3. A silica glass jig for semiconductor industry described in Claim 1 or 2, wherein the maximum width of the bottom portions of the pyramidal projected structures with their cut-off apices is from 70 to 1000 µm and a height from the bottom portions to the top portions of the projected structures is from 10 to 100 µm, and the maximum width of the bottom portions of the small projections uniformly distributed on the protruded structures is from 1 to 50 µm and the height thereof from the bottom portions to the top portions is from 0.1 to 10 µm.

4. A silica glass jig for semiconductor industry described in one of the preceeeding Claim 1 to 3, wherein the average roughness Ra of the silica glass jig for semiconductor industry is in a range of from 1 to 10 µm.

5. A method for producing a silica glass jig for semiconductor industry, **characterized by** machining the surface of the silica glass jig to form irregularities, and then treating the resulting surface with a treating solution containing hydrogen fluoride and ammonium fluoride.

6. A method for producing a silica glass jig for semiconductor industry described in Claim 5, wherein the treating solution further contains an organic carboxylic acid.

7. A method for producing a silica glass jig for semiconductor industry described in Claims 6, wherein the organic carboxylic acid is acetic acid

8. A method for producing a silica glass jig for semiconductor industry described in Claim 5, wherein the machining is a sandblasting treatment.

9. A method for producing a silica glass jig for semiconductor industry described in preceeding Claims 5 to 7, wherein the treating solution contains from 10 to 30 % by mass of hydrogen fluoride, from 5 to 30 % by mass of ammonium fluoride, from 45 to 70 % by mass of an organic carboxylic acid, and rest being water.

10. A method for producing a silica glass jig for semiconductor industry by immersing the silica glass jig in a first processing solution containing hydrogen fluoride, ammonium fluoride, and an organic acid, and then immersing it at least once in a second processing solution, wherein the content of the organic acid is higher than that of the first processing solution.

11. A method for producing a silica glass jig for semiconductor industry, described in Claim 10, wherein the first processing solution is an aqueous solution containing from 15 to 50 % by mass of hydrogen fluoride, from 6 to 30 % by mass of ammonium fluoride, and from 30 to 50 % by mass of an organic acid, and the second processing solution is a processing solution containing from 5 to 20 % by mass of hydrogen fluoride, from 6 to 30 % by mass of ammonium fluoride, and from 40 to 70 % by mass of the organic acid.

12. A method for producing a silica glass jig for semiconductor industry described in Claim 11, wherein the organic acid is acetic acid

## Patentansprüche

1. Quarzglasvorrichtung für die Halbleiterindustrie, **gekennzeichnet durch** auf der Oberfläche der vorgenannten Vorrichtung vorgesehene, pyramidenförmige vorstehende Strukturen mit ihren abgeschnittenen Scheiteln und dazwischen liegende konkave Bereiche sowie kleine Vorsprünge, die gleichmäßig darauf verteilt sind.

2. Quarzglasvorrichtung für die Halbleiterindustrie nach Anspruch 1, **dadurch gekennzeichnet, dass** auf deren Oberfläche die konkaven Bereiche grübchenförmig sind und jeder Bereich eine Breite von 20 bis 300 µm hat und Rillen vorhanden sind, von denen jede eine Breite von 0,5 bis 50 µm im Abstand von 20 bis 300 µm hat, und zwischen den Rillen und in den Rillen kleine Vorsprünge mit jeweils einer Breite von 1 bis 50 µm und einer Höhe von 0,1 bis 10 µm gleichmäßig verteilt sind.

3. Quarzglasvorrichtung für die Halbleiterindustrie nach Anspruch 1 oder 2, wobei die maximale Breite der Bodenbereiche der pyramidenförmigen vorstehenden Strukturen mit ihren abgeschnittenen Scheiteln zwischen 70 und 1000 µm beträgt und die Höhe von den Bodenbereichen zu den Spitzenbereichen der vorstehenden Strukturen zwischen 10 und 100 µm beträgt, und die maximale Breite der Bodenbereiche der kleinen Vorsprünge, die gleichmäßig auf den vorspringenden Strukturen verteilt sind, zwischen 1 und 50 µm beträgt und deren Höhe von den Bodenbereichen zu den Spitzenbereichen zwischen 0,1 und 10 µm beträgt.

4. Quarzglasvorrichtung für die Halbleiterindustrie nach einem der vorhergehenden Ansprüche 1 bis 3, wobei die Durchschnittsrauhigkeit Ra der Quarzglasvorrichtung für die Halbleiterindustrie im Bereich von 1 bis 10 µm liegt.

5. Verfahren zur Herstellung einer Quarzglasvorrichtung für die Halbleiterindustrie, **gekennzeichnet durch** die maschinelle Bearbeitung der Oberfläche der Quarzglasvorrichtung zur Bildung von Unregelmäßigkeiten und **durch** die anschließende Behandlung der entstehenden Oberfläche mit einer Behandlungslösung, die Fluorwasserstoff und Fluorammonium enthält.

6. Verfahren zur Herstellung einer Quarzglasvorrichtung für die Halbleiterindustrie nach Anspruch 5, wobei die Behandlungslösung des Weiteren eine organische Carbonsäure enthält.

7. Verfahren zur Herstellung einer Quarzglasvorrichtung für die Halbleiterindustrie nach Anspruch 6, wobei die organische Carbonsäure Essigsäure ist.

8. Verfahren zur Herstellung einer Quarzglasvorrichtung für die Halbleiterindustrie nach Anspruch 5, wobei die maschinelle Bearbeitung eine Sandstrahlbehandlung ist.

9. Verfahren zur Herstellung einer Quarzglasvorrichtung für die Halbleiterindustrie nach den vorhergehenden Ansprüchen 5 bis 7, wobei die Behandlungslösung 10 bis 30 Masse-% Fluorwasserstoff, 5 bis 30 Masse-% Fluorammonium, 45 bis 70 Masse-% einer organischen Carbonsäure sowie Wasser als Rest enthält.

10. Verfahren zur Herstellung einer Quarzglasvorrichtung für die Halbleiterindustrie durch Eintauchen der Quarzglasvorrichtung in eine erste Bearbeitungslösung, die Fluorwasserstoff, Fluorammonium sowie eine organische Säure enthält, und durch anschließendes Eintauchen derselben mindestens einmal in eine zweite Bearbeitungslösung, wobei der Gehalt der organischen Säure höher als jener der ersten Bearbeitungslösung ist.

11. Verfahren zur Herstellung einer Quarzglasvorrichtung für die Halbleiterindustrie nach Anspruch 10, wobei die erste Bearbeitungslösung eine wässrige Lösung mit 15 bis 50 Masse-% Fluorwasserstoff, 6 bis 30 Masse-% Fluorammonium und 30 bis 50 Masse-% einer organischen Säure enthält und die zweite Bearbeitungslösung eine Bearbeitungslösung ist, die 5 bis 20 Masse-% Fluorwasserstoff, 6 bis 30 Masse-% Fluorammonium und 40 bis 70 Masse-% der organischen Säure enthält.

12. Verfahren zur Herstellung einer Quarzglasvorrichtung für die Halbleiterindustrie nach Anspruch 11, wobei die organische Säure Essigsäure ist.

## Revendications

1. Gabarit en verre de silice pour l'industrie des semi-conducteurs, **caractérisé par** le fait d'avoir sur la surface du gabarit décrit précédemment des structures saillantes en forme de pyramide avec leurs parties coupées et leurs portions concaves entre ces dernières et des petites protubérances sont distribuées de manière uniforme dessus.

2. Gabarit en verre de silice pour l'industrie des semi-conducteurs, décrit dans la revendication 1, **caractérisé en ce que** sur la surface de ce dernier les portions concaves sont chanfreinées et chacune avec une largeur comprise entre 20 et 300 µm et entre les rainures et dans les rainures des petites projections ayant chacune une largeur comprise entre 1 et 50 µm et une hauteur comprise entre 0,1 et 10 µm sont réparties uniformément.

3. Gabarit en verre de silice pour l'industrie des semi-conducteurs, décrit dans la revendication 1 ou 2, dans lequel la largeur maximale des portions de fond des structures saillantes pyramidales avec leurs parties découpées est comprise entre 70 et 1000 µm et une hauteur depuis les portions inférieures et les portions supérieures des structures protubérantes est comprise entre 10 et 100 µm et la largeur maximale des portions inférieures des petites protubérances distribuées uniformément sur les structures saillantes est comprise entre 1 et 50 µm et leur hauteur entre les portions inférieures et les portions supérieures est comprise entre 0,1 et 10 µm.

4. Gabarit en verre de silice pour l'industrie des semi-conducteurs, décrit dans l'une des revendications 1 à 3 dans lequel la rugosité moyenne Ra du gabarit en verre de silice pour l'industrie des semi-conducteurs est comprise entre 1 et 10 µm.

5. Procédé pour la fabrication d'un gabarit de verre de silice pour l'industrie des semi-conducteurs **caractérisé par** l'usinage de la surface du gabarit en verre de silice pour former des irrégularités et ensuite traitement de la surface en résultant avec une solution de traitement contenant des fluorures d'hydrogène et des fluorures d'ammonium.

6. Procédé pour la fabrication d'un gabarit de verre de silice pour l'industrie des semi-conducteurs décrit dans la revendication 5, dans lequel la solution de traitement contient en outre un acide organique carboxylique.

7. Procédé pour la fabrication d'un gabarit de verre de silice pour l'industrie des semi-conducteurs décrit dans la revendication 6, dans lequel l'acide organique carboxylique est l'acide acétique.

8. Procédé pour la fabrication d'un gabarit de verre de silice pour l'industrie des semi-conducteurs décrit dans la revendication 5, dans lequel l'usinage est un traitement de décapage au sable

9. Procédé pour la fabrication d'un gabarit de verre de silice pour l'industrie des semi-conducteurs décrit dans les revendications précédentes 5 à 7, dans lequel la solution de traitement contient de 10 à 30 % en masse de fluorure d'hydrogène, de 5 à 30 % en masse de fluorure d'ammonium, de 45 à 70 % en masse d'un acide organique carboxylique et le reste étant de l'eau

10. Procédé pour la fabrication d'un gabarit de verre de silice pour l'industrie des semi-conducteurs par immersion du gabarit de verre de silice dans une première solution de traitement contenant du fluorure d'hydrogène, du fluorure d'ammonium et un acide organique et ensuite immersion au moins une fois dans une seconde solution de traitement dans lequel le contenue des acides organiques est plus élevée que celle de la première solution de traitement.

11. Procédé pour la fabrication d'un gabarit de verre de silice pour l'industrie des semi-conducteurs décrit dans la revendication 10, dans lequel la première solution de traitement est une solution aqueuse contenant de 15 à 50 % en masse de fluorure d'hydrogène, de 6 à 30 % en masse de fluorure d'ammonium et de 30 à 50 % en masse d'un acide organique et la seconde solution de traitement est une solution de traitement contenant de 5 à 20 % en masse de fluorure d'hydrogène, de 6 à 30 % en masse de fluorure d'ammonium et de 40 à 70 % en masse d'un acide organique.

12. Procédé pour la fabrication d'un gabarit de verre de silice pour l'industrie des semi-conducteurs décrit dans la revendication 11, l'acide organique est l'acide acétique.
